# EUROPEAN PATENT SPECIFICATION

(11) **EP 4 402 753 B1**
(45) Date of publication and mention of the grant of the patent: **12.08.2026**
(21) Application number: 22873788.8
(22) Date of filing: 16.09.2022
(51) Int. Cl.: H01Q 1/38, H05K 1/02, H01P 5/02, H01Q 1/22, H01Q 3/00, H01Q 21/06, H05K 1/16, H01Q 21/24, H01Q 3/26

(54) **DOUBLE BACK DRILL VIA FOR LOW COST PCB MMWAVE PHASED ARRAY ANTENNAS**
DOPPELRÜCKBOHRUNG FÜR KOSTENGÜNSTIGE PCB-MILLIMETERWELLEN-PHASENGESTEUERTE GRUPPENANTENNEN
TROU D'INTERCONNEXION À PERÇAGE ARRIÈRE DOUBLE POUR ANTENNES RÉSEAU À COMMANDE DE PHASE À ONDES MILLIMÉTRIQUES À CARTE DE CIRCUIT IMPRIME À FAIBLE COÛT

(30) Priority: 22.09.2021 US 202163261477 P
(43) Date of publication of application: 24.07.2024
(73) Proprietor: Jabil Inc., St. Petersburg, FL 33716 (US)
(72) Inventor: TIMMINS, Ian, Jeffery, St. Petersburg, FL 33716 (US); RAFIE, Babak, Zarrin, St. Petersburg, FL 33716 (US); FALTONE, Youssef, St. Petersburg, FL 33716 (US); FINNELL, John, St. petersburg, FL 33716 (US)
(74) Representative: Gulde & Partner
(86) International application number: PCT/US2022/076544
(87) International publication number: WO 2023/049662

(56) References cited:
- US-A1- 2009 256 752
- US-A1- 2010 066 631
- US-A1- 2010 126 010
- US-A1- 2016 344 098
- US-A1- 2018 342 810
- US-A1- 2020 091 608
- US-A1- 2020 212 539
- US-A1- 2021 066 814
- WATANABE ATOM O. ET AL: "Low-Loss Impedance-Matched Sub-25-[mu]m Vias in 3-D Millimeter-Wave Packages", IEEE TRANSACTIONS ON COMPONENTS, PACKAGING AND MANUFACTURING TECHNOLOGY IEEE, USA, vol. 10, no. 5, 20 March 2020 (2020-03-20), pages 870 - 877, XP011787503, ISSN: 2156-3950, [retrieved on 20200508], DOI: 10.1109/TCPMT.2020.2982294

## Description

### BACKGROUND

### Field

This disclosure relates generally to a millimeter wave (mmWave) antenna and, more particularly, to a mmWave phased array antenna including interconnected back-drilled vias.

### Discussion of the Related Art

Cellular telecommunications companies began deploying fifth generation (5G) radio technology standard for cellular networks in 2019. The 5G radio standard utilizes a higher frequency spectrum than previous generations of commercial communications technologies. MmW phased array antennas are being designed and developed for the 5G protocol that provides increased performance over 4G systems while also reducing costs. 5G mmWave antennas typically require precise manufacturing of printed circuit boards (PCBs) because antenna features on the order of a wavelength are at the limits of manufacturing tolerance of the PCB fabrication process.

One of the most challenging RF circuits for the development of a PCB based phased array antenna design is the transition structures, i.e., vias, between layers in the PCB. For example, the transition from the feed layer to the radiating elements, where these vias tend to be the largest vias on the PCB structure, is difficult to produce. Generally, these antenna designs include a high layer count PCB that tends toward using microvias as interconnect structures between the layers. This makes for a complex PCB fabrication process that is not suited to low cost high volume manufacturing. Furthermore, there have been PCB fabrication development methods to support fine pitch ball grid array (BGA) packages in application specific integrated circuit (ASIC) designs, where a conventional PCB is used, with plated through hole (PTH) vias, and then a number of subsequent prepreg layers using microvias are added to the PCB structure as a technique to provide trace routing to "break out" of the fine pitch BGA, which otherwise using PTH via technology would prove challenging, or even impossible as pin counts on the BGA ASIC increase. US 20100126010 A1 discloses phased array antennas, wherein the tile sub-array comprises a board and an upper multi-layer board, the board comprises two vias extending to the bottom surface of the board and extending to the top surface of the board, the two vias are interconnected by interconnect, the multi-layer board comprises on each of the top and bottom side dielectric layers that constitute prepreg buildup layers, the beamforming circuitry is provided at the lower portion of the board, and the radiating elements are located at a top side of the board. US 2020212539 A1 discloses a phased array antenna, wherein the plurality of conductive layers and the plurality of via holes may form a plurality of feeding paths, the plurality of via holes may be filled with a conductive material, the conductive patch and the wireless communication circuit may be electrically connected through the plurality of feeding paths, and the conductive patch may be fed through the plurality of feeding paths. Watanabe, A. O., et al., "Low-Loss Impedance-Matched Sub-25-µm Vias in 3-D Millimeter-Wave Packages", IEEE Transactions on Components, Packaging and Manufacturing Technology, Vol. 10, No. 5, May 2020, pages 870-876 discloses the development of sub-25-µm microvias designed for high-density, 3-D millimeter-wave 5G antenna packages. These microvias are located in the buildup layers to provide vertical electrical interconnections between the redistribution layers and the core substrate.

### SUMMARY

The following discussion discloses and describes a mmWave phased array antenna that has particular application to be used in a 5G radio. The antenna is provided as defined by the appended set of claims.

Additional features of the disclosure will become apparent from the following description and appended claims, taken in conjunction with the accompanying drawings.

### BRIEF DESCRIPTION OF THE DRAWINGS

Figure 1 is a profile view of a mmWave phased array antenna including interconnected back-drilled vias; and
Figure 2 is a layout illustration of the mmWave antenna showing a beamforming IC, a patch antenna and the interconnected back-drilled vias.

### DETAILED DESCRIPTION

The following discussion of the embodiments of the disclosure directed to a mmWave phased array antenna including interconnected back-drilled vias is merely exemplary in nature, and is in no way intended to limit the disclosure or its applications or uses. For example, the discussion herein refers to the antenna as being part of a phased array antenna for a 5G radio. However, as will be appreciated by those skilled in the art, the antenna will have other applications.

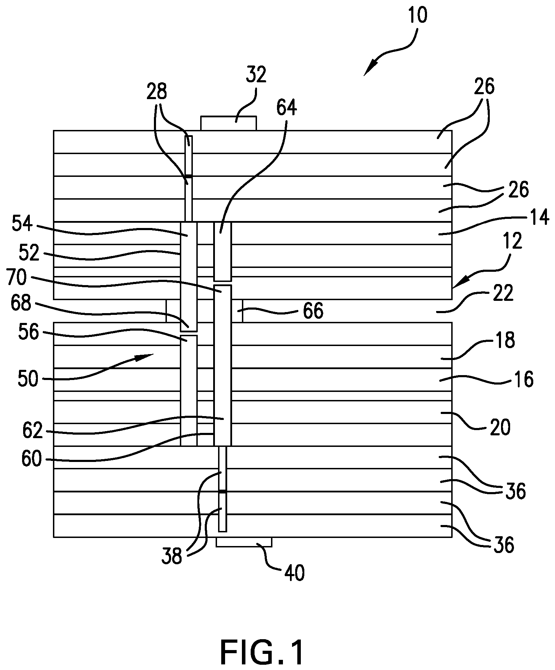

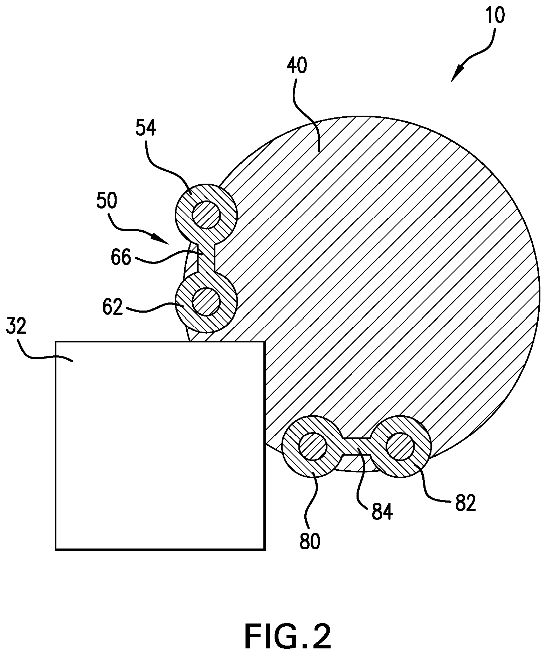

Figure 1 is a profile view a mmWave phased array antenna 10 and figure 2 is a layout illustration of a portion of the mmWave antenna 10, where the antenna 10 can be part of a 5G radio. The antenna 10 includes a PCB structure 12 having a stack of layers 14 including core dielectric layers 16, dielectric insulating prepreg layers 18, copper layers 20 and a feed layer 22, where the number, thickness, configuration, material, etc. of the layers 14 would be designed for a particular antenna as would be well understood by those skilled in the art. Prepreg buildup layers 26 are formed on a top of the PCB structure 12 and stacked microvias 28 are formed through the layers 26, where the layers 26 and the microvias 28 support BGA breakup. A beamforming IC 32 is provided on top of the buildup layers 26 and includes the circuitry necessary for beam phase combining and beam steering for multiple radiating elements in the phased array antenna 10 in a manner well understood by those skilled in the art, where the vias 28 provide an electrical connection to the beamforming IC 32. Multiple beamforming ICs would be employed in the phased array antenna 10. Prepreg buildup layers 36 are formed on a bottom of the PCB structure 12 and stacked microvias 38 are formed through the layers 36, where the layers 36 and the microvias 38 support BGA breakup. A patch antenna radiating element 40 is formed on an outermost one of the layers 36 and would be one of many radiating elements formed on the PCB structure 12 to provide the phased array antenna 10, where the radiating element 40 could be formed of ½ oz copper, and where the vias 38 provide an electrical connection to the radiating element 40.

Prior to the layers 26 and 36 being formed on the PCB structure 12, a via structure 50 is formed in the PCB structure 12 to provide an electrical connection between the vias 28 and 38, and thus between the beamforming IC 32 and the radiating element 40. A hole 52 is drilled from the top side of the PCB structure 12 and a via 54 is formed in part of the hole 52 and the rest of the hole 52 is filled with a dielectric 56. A hole 60 is drilled from the bottom side of the PCB structure 12 and a via 62 is formed in part of the hole 60 and the rest of the hole 60 is filled with a dielectric 64, where the holes 52 and 60 are provided as close together as the manufacturing tolerances will allow. An interconnect 66 in the feed layer 22 electrically couples the vias 54 and 62. A stub 68 of the via 54 extends past the interconnect 66 adjacent to the dielectric 56 and a stub 70 of the via 62 extends past the interconnect 66 adjacent to the dielectric 64 and have a length for impedance matching purposes between the vias 54 and 62.

Figure 2 shows an additional set of vias 80 and 82 connected by an interconnect 84 and orthogonal to the vias 54 and 62 to support another signal polarization.

The foregoing discussion discloses and describes merely exemplary embodiments of the present disclosure. One skilled in the art will readily recognize from such discussion and from the accompanying drawings and claims that various changes, modifications and variations can be made therein without departing from the scope of the disclosure as defined in the following claims.

## Claims

1. An antenna (10) comprising:
a printed circuit board, PCB, structure (12) including a plurality of layers (14), said PCB structure (12) including a first via hole (52) formed into the layers (14) through one side of the PCB structure (12) and partially filled with a first via (54) and a second via hole (60) formed into the layers (14) through an opposite side of the PCB structure (12) and partially filled with a second via (62), wherein the first and second vias (54, 62) are electrically coupled by an interconnect (66);
prepreg buildup layers (26) formed on the one side of the PCB structure (12) and prepreg buildup layers (36) formed on the opposite side of the PCB structure (12);
at least one beamforming integrated circuit, IC, (32) formed on the prepreg buildup layers (26) on the one side of the PCB structure (12); and
at least one antenna radiating element (40) formed on the prepreg buildup layers (36) on the opposite side of the PCB structure (12), wherein the prepreg layers (26) on the one side of the PCB structure (12) include microvias (28) electrically coupled to the beam forming IC (32) and the first via (54) and the prepreg buildup layers (36) on the opposite side of the PCB structure (12) include microvias (38) electrically coupled to the at least one antenna radiating element (40) and the second via (62).

2. The antenna (10) according to claim 1 wherein the first via (54) includes a first stub (68) that extends beyond the interconnect (66) and the second via (62) includes a second stub (70) that extends beyond the interconnect (66).

3. The antenna (10) according to claim 1 wherein the at least one antenna radiating element (40) is a patch antenna radiating element (40).

4. The antenna (10) according to claim 1 wherein the interconnect (66) is in a feed layer (22) in the PCB structure (12).

5. The antenna (10) according to claim 1 wherein the antenna (10) is a phased array antenna, the at least one beamforming IC (32) is a plurality of beamforming ICs and the at least one antenna radiating element (40) is a plurality of antenna radiating elements.

6. The antenna (10) according to claim 1 wherein the portion of the first via hole (52) that is not filled with the first via (54) is filled with a dielectric (56) and the portion of the second via hole (60) that is not filled with the second via (62) is filled with a dielectric (64).

7. A phased array antenna (10) comprising:
a printed circuit board, PCB, structure (12) including a plurality of layers (14), said PCB structure (12) including a first via hole (52) formed into the layers (14) through one side of the PCB structure (12) and partially filled with a first via (54) and a second via hole (60) formed into the layers (14) through an opposite side of the PCB structure (12) and partially filled with a second via (62), wherein the first and second vias (54, 62) are electrically coupled by an interconnect (66) provided in a feed layer (22) of the plurality of layers (14);
prepreg buildup layers (26) formed on the one side of the PCB structure (12) and prepreg buildup layers (36) formed on the opposite side of the PCB structure (12);
at least one beamforming integrated circuit, IC, (32) formed on the prepreg buildup layers (26) on the one side of the PCB structure (12); and
at least one patch antenna radiating element (40) formed on the prepreg buildup layers (36) on the opposite side of the PCB structure (12), wherein the prepreg layers (26) on the one side of the PCB structure (12) include microvias (28) electrically coupled to the beam forming IC (32) and the first via (54) and the prepreg buildup layers (36) on the opposite side of the PCB structure (12) include microvias (38) electrically coupled to the at least one antenna radiating element (40) and the second via (62).

8. The antenna (10) according to claim 7 wherein the first via (54) includes a first stub (68) that extends beyond the interconnect (66) and the second via (62) includes a second stub (70) that extends beyond the interconnect (66).

9. The antenna (10) according to claim 7 wherein the portion of the first via hole (52) that is not filled with the first via (54) is filled with a dielectric (56) and the portion of the second via hole (60) that is not filled with the second via (62) is filled with a dielectric (64).

## Patentansprüche

1. Antenne (10), umfassend:
eine Leiterplatten-, PCB, -Struktur (12), die eine Mehrzahl von Schichten (14) enthält, wobei die PCB-Struktur (12) ein erstes Durchkontaktierungsloch (52) enthält, das in den Schichten (14) durch eine Seite der PCB-Struktur (12) ausgebildet ist und teilweise mit einer ersten Durchkontaktierung (54) gefüllt ist, und ein zweites Durchkontaktierungsloch (60) enthält, das in den Schichten (14) durch eine gegenüberliegende Seite der PCB-Struktur (12) ausgebildet ist und teilweise mit einer zweiten Durchkontaktierung (62) gefüllt ist, wobei die erste und zweite Durchkontaktierung (54, 62) durch eine Verbindung (66) elektrisch gekoppelt sind;
Prepreg-Aufbauschichten (26), die auf der einen Seite der PCB-Struktur (12) ausgebildet sind, und Prepreg-Aufbauschichten (36), die auf der gegenüberliegenden Seite der PCB-Struktur (12) ausgebildet sind;
mindestens eine strahlformende integrierte Schaltung, IC, (32), die auf den Prepreg-Aufbauschichten (26) auf der einen Seite der PCB-Struktur (12) ausgebildet ist; und
mindestens ein Antennenabstrahlelement (40), das auf den Prepreg-Aufbauschichten (36) auf der gegenüberliegenden Seite der PCB-Struktur (12) ausgebildet ist, wobei die Prepreg-Schichten (26) auf der einen Seite der PCB-Struktur (12) Mikrodurchkontaktierungen (28) enthalten, die mit der strahlformenden IC (32) und der ersten Durchkontaktierung (54) elektrisch gekoppelt sind, und die Prepreg-Aufbauschichten (36) auf der gegenüberliegenden Seite der PCB-Struktur (12) Mikrodurchkontaktierungen (38) enthalten, die mit dem mindestens einen Antennenabstrahlelement (40) und der zweiten Durchkontaktierung (62) elektrisch gekoppelt sind.

2. Antenne (10) nach Anspruch 1, wobei die erste Durchkontaktierung (54) eine erste Stichleitung (68) enthält, die sich über die Verbindung (66) hinaus erstreckt, und die zweite Durchkontaktierung (62) eine zweite Stichleitung (70) enthält, die sich über die Verbindung (66) hinaus erstreckt.

3. Antenne (10) nach Anspruch 1, wobei das mindestens eine Antennenabstrahlelement (40) ein Patch-Antennenabstrahlelement (40) ist.

4. Antenne (10) nach Anspruch 1, wobei sich die Verbindung (66) in einer Speiseschicht (22) in der PCB-Struktur (12) befindet.

5. Antenne (10) nach Anspruch 1, wobei die Antenne (10) eine phasengesteuerte Gruppenantenne ist, die mindestens eine strahlformende IC (32) eine Mehrzahl von strahlformenden ICs ist und das mindestens eine Antennenabstrahlelement (40) eine Mehrzahl von Antennenabstrahlelementen ist.

6. Antenne (10) nach Anspruch 1, wobei der Abschnitt des ersten Durchkontaktierungslochs (52), der nicht mit der ersten Durchkontaktierung (54) gefüllt ist, mit einem Dielektrikum (56) gefüllt ist, und der Abschnitt des zweiten Durchkontaktierungslochs (60), der nicht mit der zweiten Durchkontaktierung (62) gefüllt ist, mit einem Dielektrikum (64) gefüllt ist.

7. Phasengesteuerte Gruppenantenne (10), umfassend:
eine Leiterplatten-, PCB, -Struktur (12), die eine Mehrzahl von Schichten (14) enthält, wobei die PCB-Struktur (12) ein erstes Durchkontaktierungsloch (52) enthält, das in den Schichten (14) durch eine Seite der PCB-Struktur (12) ausgebildet ist und teilweise mit einer ersten Durchkontaktierung (54) gefüllt ist, und ein zweites Durchkontaktierungsloch (60) enthält, das in den Schichten (14) durch eine gegenüberliegende Seite der PCB-Struktur (12) ausgebildet ist und teilweise mit einer zweiten Durchkontaktierung (62) gefüllt ist, wobei die erste und zweite Durchkontaktierung (54, 62) durch eine Verbindung (66), die in einer Speiseschicht (22) der Mehrzahl von Schichten (14) angeordnet ist, elektrisch gekoppelt sind;
Prepreg-Aufbauschichten (26), die auf der einen Seite der PCB-Struktur (12) ausgebildet sind, und Prepreg-Aufbauschichten (36), die auf der gegenüberliegenden Seite der PCB-Struktur (12) ausgebildet sind;
mindestens eine strahlformende integrierte Schaltung, IC, (32), die auf den Prepreg-Aufbauschichten (26) auf der einen Seite der PCB-Struktur (12) ausgebildet ist; und
mindestens ein Patch-Antennenabstrahlelement (40), das auf den Prepreg-Aufbauschichten (36) auf der gegenüberliegenden Seite der PCB-Struktur (12) ausgebildet ist, wobei die Prepreg-Schichten (26) auf der einen Seite der PCB-Struktur (12) Mikrodurchkontaktierungen (28) enthalten, die mit der strahlformenden IC (32) und der ersten Durchkontaktierung (54) elektrisch gekoppelt sind, und die Prepreg-Aufbauschichten (36) auf der gegenüberliegenden Seite der PCB-Struktur (12) Mikrodurchkontaktierungen (38) enthalten, die mit dem mindestens einen Antennenabstrahlelement (40) und der zweiten Durchkontaktierung (62) elektrisch gekoppelt sind.

8. Antenne (10) nach Anspruch 7, wobei die erste Durchkontaktierung (54) eine erste Stichleitung (68) enthält, die sich über die Verbindung (66) hinaus erstreckt, und die zweite Durchkontaktierung (62) eine zweite Stichleitung (70) enthält, die sich über die Verbindung (66) hinaus erstreckt.

9. Antenne (10) nach Anspruch 7, wobei der Abschnitt des ersten Durchkontaktierungslochs (52), der nicht mit der ersten Durchkontaktierung (54) gefüllt ist, mit einem Dielektrikum (56) gefüllt ist, und der Abschnitt des zweiten Durchkontaktierungslochs (60), der nicht mit der zweiten Durchkontaktierung (62) gefüllt ist, mit einem Dielektrikum (64) gefüllt ist.

## Revendications

1. Antenne (10) comprenant :
une structure de carte de circuit imprimé, PCB, (12) comprenant une pluralité de couches (14), ladite structure PCB (12) comprenant un premier trou de via (52) formé dans les couches (14) à travers un côté de la structure PCB (12) et partiellement rempli par un premier via (54), et un deuxième trou de via (60) formé dans les couches (14) à travers un côté opposé de la structure PCB (12) et partiellement rempli par un deuxième via (62), dans lequel les premier et deuxième vias (54, 62) sont couplés électriquement par une interconnexion (66) ;
des couches d'empilage de préimprégné (26) formées sur ledit un côté de la structure PCB (12) et des couches d'empilage de préimprégné (36) formées sur le côté opposé de la structure PCB (12) ;
au moins un circuit intégré de formation de faisceau, IC, (32) formé sur les couches d'empilage de préimprégné (26) sur ledit un côté de la structure PCB (12) ; et
au moins un élément rayonnant d'antenne (40) formé sur les couches d'empilage de préimprégné (36) sur le côté opposé de la structure PCB (12), dans lequel les couches de préimprégné (26) sur ledit un côté de la structure PCB (12) comprennent des microvias (28) couplés électriquement au circuit intégré de formation de faisceau (32) et au premier via (54), et les couches d'empilage de préimprégné (36) sur le côté opposé de la structure PCB (12) comprennent des microvias (38) couplés électriquement audit au moins un élément rayonnant d'antenne (40) et au deuxième via (62).

2. Antenne (10) selon la revendication 1, dans laquelle le premier via (54) comprend un premier tronçon résiduel (68) qui s'étend au-delà de l'interconnexion (66) et le deuxième via (62) comprend un deuxième tronçon résiduel (70) qui s'étend au-delà de l'interconnexion (66).

3. Antenne (10) selon la revendication 1, dans laquelle ledit au moins un élément rayonnant d'antenne (40) est un élément rayonnant d'antenne patch (40).

4. Antenne (10) selon la revendication 1, dans laquelle l'interconnexion (66) se trouve dans une couche d'alimentation (22) de la structure PCB (12).

5. Antenne (10) selon la revendication 1, dans laquelle l'antenne (10) est une antenne réseau à commande de phase, ledit au moins un IC de formation de faisceau (32) est une pluralité d'IC de formation de faisceau et ledit au moins un élément rayonnant d'antenne (40) est une pluralité d'éléments rayonnants d'antenne.

6. Antenne (10) selon la revendication 1, dans laquelle la portion du premier trou de via (52) qui n'est pas remplie par le premier via (54) est remplie par un diélectrique (56), et la portion du deuxième trou de via (60) qui n'est pas remplie par le deuxième via (62) est remplie par un diélectrique (64).

7. Antenne réseau à commande de phase (10) comprenant :
une structure de carte de circuit imprimé, PCB, (12) comprenant une pluralité de couches (14), ladite structure PCB (12) comprenant un premier trou de via (52) formé dans les couches (14) à travers un côté de la structure PCB (12) et partiellement rempli par un premier via (54), et un deuxième trou de via (60) formé dans les couches (14) à travers un côté opposé de la structure PCB (12) et partiellement rempli par un deuxième via (62), dans lequel les premier et deuxième vias (54, 62) sont couplés électriquement par une interconnexion (66) fournie dans une couche d'alimentation (22) de la pluralité de couches (14) ;
des couches d'empilage de préimprégné (26) formées sur ledit un côté de la structure PCB (12) et des couches d'empilage de préimprégné (36) formées sur le côté opposé de la structure PCB (12) ;
au moins un circuit intégré de formation de faisceau, IC, (32) formé sur les couches d'empilage de préimprégné (26) sur ledit un côté de la structure PCB (12) ; et
au moins un élément rayonnant d'antenne patch (40) formé sur les couches d'empilage de préimprégné (36) sur le côté opposé de la structure PCB (12), dans lequel les couches de préimprégné (26) sur ledit un côté de la structure PCB (12) comprennent des microvias (28) couplés électriquement au circuit intégré de formation de faisceau (32) et au premier via (54), et les couches d'empilage de préimprégné (36) sur le côté opposé de la structure PCB (12) comprennent des microvias (38) couplés électriquement audit au moins un élément rayonnant d'antenne (40) et au deuxième via (62).

8. Antenne (10) selon la revendication 7, dans laquelle le premier via (54) comprend un premier tronçon résiduel (68) qui s'étend au-delà de l'interconnexion (66) et le deuxième via (62) comprend un deuxième tronçon résiduel (70) qui s'étend au-delà de l'interconnexion (66).

9. Antenne (10) selon la revendication 7, dans laquelle la portion du premier trou de via (52) qui n'est pas remplie par le premier via (54) est remplie par un diélectrique (56), et la portion du deuxième trou de via (60) qui n'est pas remplie par le deuxième via (62) est remplie par un diélectrique (64).
